# EUROPÄISCHE PATENTSCHRIFT

(11) **EP 3 791 375 B1**
(45) Veröffentlichungstag und Bekanntmachung des Hinweises auf die Patenterteilung: **28.01.2026**
(21) Anmeldenummer: 19733674.6
(22) Anmeldetag: 05.06.2019
(51) Int. Cl.: G05B 19/042, G05B 23/02, G05D 1/00, G06F 11/07, H04L 67/12, H04W 84/18, G08G 1/01, G08G 1/0965, G08G 1/0967, G08G 1/00, G07C 5/00, G08G 1/017

(54) **VERFAHREN UND VORRICHTUNG ZUR GEGENSEITIGEN ÜBERWACHUNG UND/ODER KONTROLLE AUTONOMER TECHNISCHER SYSTEME**
METHOD AND DEVICE FOR MUTUAL MONITORING AND/OR CONTROL OF AUTONOMOUS TECHNICAL SYSTEMS
PROCÉDÉ ET DISPOSITIF DE SURVEILLANCE ET/OU DE COMMANDE MUTUELLE DE SYSTÈMES TECHNIQUES AUTONOMES

(30) Priorität: 19.06.2018 DE 102018209868
(43) Veröffentlichungstag der Anmeldung: 17.03.2021
(73) Patentinhaber: Robert Bosch GmbH, 70839 Gerlingen-Schillerhöhe (DE)
(72) Erfinder: DIETRICH, Vincent, 80639 München (DE); MEISTER, Philine, Sunnyvale, CA 94086 (US); FIEGERT, Michael, 81739 München (DE); LIU, Ziyuan, 85521 Ottobrunn (DE); MESANOVIC, Amer, 80992 München (DE); MEYER-DELIUS DI VASTO, Daniel, 81541 München (DE); SZABO, Andrei, 85521 Ottobrunn (DE); WURM, Kai, 81739 München (DE)
(74) Vertreter: Bee, Joachim
(86) Internationale Anmeldenummer: PCT/EP2019/064647
(87) Internationale Veröffentlichungsnummer: WO 2019/243052

(56) Entgegenhaltungen:
- WO-A1-2017/035516
- WO-A1-2018/035145
- DE-A1- 102016 007 588
- US-A1- 2017 227 972

## Beschreibung

Die Erfindung betrifft ein Verfahren und eine Vorrichtung zur gegenseitigen Überwachung und/oder Kontrolle einer Vielzahl autonomer technischer Systeme, die zumindest teilweise untereinander über ein Kommunikationsnetzwerk vernetzt sind.

Unter autonomen technischen Systemen können beispielsweise autonome Fahrzeuge, Geräte oder Roboter verstanden werden, welche sich beispielsweise autonom bewegen oder selbsttätig agieren können. Autonome technische Systeme können zunehmend in verschiedenen Domänen eingesetzt werden. Systemfehler, wie z.B. Software- oder Hardwarefehler oder Fehlfunktionen durch Manipulation können dabei schwerwiegende Konsequenzen für die Sicherheit der autonomen technischen Systeme selbst und/oder Menschen und technische Systeme in ihrer Umgebung haben. Es ist bekannt, Sicherheitsmechanismen an einem autonomen Gerät oder in einem autonomen Fahrzeug zu implementieren. Als Beispiele sind hier physische Sicherheitsmaßnahmen, wie z.B. Trennung einer Funkverbindung zu einer Steuerung, digitale Sicherheitsmaßnahmen, wie z.B. Authentifizierung bei Funktionszugriff, intrinsisches Erkennen eines Fehlers, separate Sicherheitskreise oder Überwachungssysteme, wie z.B. durch externe Sensoren, zu nennen. Es kann allerdings häufig keine vollständige Kontrolle gewährleistet werden, insbesondere, wenn lediglich ein Sicherheitsmechanismus für ein autonomes technisches System vorhanden ist, welcher selbst fehlerhaft sein könnte oder leicht manipulierbar ist.

Aus *D1* DE 10 2016 007588 A1 *ist* ein Verfahren zur Durchführung einer Fahrt von mehreren zu einem Verbund zusammengeschlossenen Fahrzeugen offenbart, wobei ein Fahrbetrieb eines vorausfahrenden Fahrzeugs überwacht wird und bei einer ermittelten Ermüdung des Fahrers des vorausfahrenden Fahrzeugs eine Meldung ausgegeben wird.

Es ist eine Aufgabe der Erfindung, eine Möglichkeit zu schaffen, die Sicherheit eines autonomen technischen Systems und/oder einer Vielzahl autonomer technischer Systeme zu verbessern.

Die Aufgabe wird gelöst durch eine Verfahren mit den Merkmalen des Patentanspruchs 1, durch eine Vorrichtung gemäß Patentanspruch 13 und einem Computerprogrammprodukt gemäß Patentanspruch 19. Vorteilhafte Ausführungsformen und Weiterbildungen der Erfindung sind in den abhängigen Ansprüchen angegeben.

Ein Vorteil der Erfindung ist beispielsweise, dass sich, insbesondere verschiedene, autonome technische Systeme untereinander überwachen können und bei einem regelwidrigen Verhalten eines der autonomen technischen Systeme dieses kontrolliert werden kann. Durch eine gemeinsame Bewertung des Betriebsverhaltens kann erreicht werden, dass ein autonomes technisches System bei einem regelwidrigen Betriebsverhalten in einen sicheren Zustand versetzt werden kann. Insbesondere kann eine Kontrolle eines autonomen technischen Systems von extern und lediglich nach gemeinsamer Prüfung und Bewertung einer Statusmeldung über das regelwidrige Betriebsverhalten durch andere autonome technische Systeme erfolgen.

Eine Bewertung kann vorzugsweise anhand ermittelter oder empfangener Daten, wie z.B. einer Zustandsinformation oder einem Messergebnis, erfolgen. Die Bewertung kann insbesondere abhängig von einer vorgegebenen ersten Regel, wie z.B. einem Tempolimit, sein. Ein autonomes technisches System kann beispielsweise anhand der ersten Regel und der empfangenen Statusmeldung bewerten bzw. abstimmen, ob ein regelwidriges Betriebsverhalten, das abhängig von der ersten Regel von einem überwachenden autonomen technischen System detektiert wurde, kontrolliert werden soll.

Die Vielzahl autonomer technischer Systeme ist über ein Kommunikationsnetzwerk vernetzt. Die Kommunikation untereinander kann beispielsweise über ein bestehendes Daten- und/oder Kommunikationsnetzwerk erfolgen. Die autonomen technischen Systeme können auch untereinander ein adhoc-Kommunikationsnetzwerk aufbauen. Es kann insbesondere eine gemeinsame Bewertung von beteiligten autonomen technischen Systemen über das Kommunikationsnetzwerk gebildet werden. Beispielsweise kann, sobald die gemeinsame Bewertung einen Wert angibt, der z.B. einen vorgegebenen Wert überschreitet, eine Kontrollvorschrift zum Steuern eines sich regelwidrig verhaltenden technischen Systems ermittelt und an dessen Kontrollmodul übermittelt werden. Insbesondere kann die gemeinsame Bewertung und/oder Abstimmung als ein dezentrales Verfahren ausgestaltet sein. Ein dezentrales Verfahren ist außerdem vorteilhaft, da es flexibel an die am Bewertungsverfahren teilnehmenden technischen Systeme angepasst werden kann.

Zum Beispiel kann ein autonomes Fahrzeug bei einer Überschreitung eines Tempolimits nach gemeinsamer Bewertung der Statusmeldung des regelwidrigen Betriebsverhaltens durch mindestens einen Teil der anderen autonomen technischen Systeme gestoppt werden. Dazu kann eine Statusmeldung über das regelwidrige Betriebsverhalten des autonomen Fahrzeugs über das Kommunikationsnetzwerk mit anderen autonomen technischen Systemen geteilt werden und von diesen bewertet werden. Das erfindungsgemäße Verfahren kann insbesondere ermöglichen, eines der autonomen technischen Systeme in einen sicheren Zustand zu versetzen, nachdem durch mindestens ein anderes autonomes technisches System eine regelwidrige Betriebsweise erkannt und durch mindestens ein anderes autonomes technisches System die Statusmeldung über das regelwidrige Betriebsverhalten bewertet wurde.

Die Vielzahl autonomer technischer Systeme kann sich insbesondere gegenseitig überwachen, untereinander Betriebsverhaltensweisen beurteilen und auf dieser Basis gemeinsam eine Kontrolle veranlassen, wenn eines der autonomen technischen Systeme sich regelwidrig verhält. Es kann außerdem beispielsweise nur ein Teil der autonomen technischen Systeme mit einem Kontrollmodul ausgestattet sein bzw. diesen jeweils ein Kontrollmodul zugeordnet sein. Es ist auch denkbar, dass ein Kontrollmodul extern angeordnet und mindestens einem autonomen technischen System zugeordnet ist, wie z.B. ausfahrbare Poller.

Vorzugsweise kann ein Kontrollmechanismus gemäß der Erfindung zusätzlich zu bereits vorhandenen Sicherheitssystemen implementiert werden. Vorzugsweise kann ein Kontrollmodul in einem autonomen technischen System integriert und derart eingerichtet sein, dass eine von extern übermittelte Kontrollvorschrift direkt umgesetzt werden kann und/oder geltende Steuerungsbefehle überschrieben, abgeändert oder außer Kraft gesetzt werden können. Eine Kontrollvorschrift kann beispielsweise einen Befehl zum Abschalten und/oder Einschränken einer Funktion umfassen. Insbesondere kann das Kontrollmodul lediglich eine Kontrollvorschrift nach vorgegebenen Regeln umsetzen, wie z.B. lediglich eine Reduzierung aber keine Erhöhung einer Geschwindigkeit.

Ein weiterer Vorteil der Erfindung kann zum Beispiel in der kontrollierten Überwachung und Kontrolle gesehen werden, da durch die gemeinsame Bewertung einer Statusmeldung beispielsweise Falschmeldungen über ein Betriebsverhalten erkannt werden können. Damit kann beispielsweise auch verhindert werden, dass das überwachende autonome technische System die Steuerung des sich regelwidrig verhaltenden autonomen technischen Systems alleine durchsetzen kann, z.B. wenn dieses überwachende autonome technische System selbst fehlerhaft ist oder manipuliert wurde.

In einer vorteilhaften Ausführungsform des Verfahrens kann ein überwachendes autonomes technisches System mindestens einen Sensor umfassen, der Sensor kann Sensordaten erfassen, und anhand der Sensordaten kann ein regelwidriges Betriebsverhalten eines der anderen autonomen technischen Systeme detektiert werden.

Ein Sensor kann beispielsweise eine Kamera in verschiedenen spektralen Wellenlängenbereichen, ein Temperaturfühler, ein Geschwindigkeits- oder Beschleunigungsmessgerät, ein Abstandsmessgerät, ein Laserscanner, ein Radar- oder Ultraschallsensor, oder ein Mikrofon sein. Vorzugsweise umfasst ein überwachendes autonomes technisches System Sensoren mit unterschiedlichen Ortsauflösungen und an verschiedenen Positionen, so dass z.B. bei einer Bewegung des überwachenden autonomen Systems das Betriebsverhalten eines anderen autonomen Systems ununterbrochen überwacht werden kann.

In einer weiteren vorteilhaften Ausführungsform des Verfahrens kann das Übertragen der Statusmeldung und/oder die gemeinsame Bewertung der Statusmeldung und/oder die Übermittlung der Kontrollvorschrift mittels einer verschlüsselten Datenübertragung über das Kommunikationsnetzwerk und/oder nach gegenseitiger Identifizierung der autonomen technischen Systeme untereinander erfolgen.

Insbesondere kann das Übertragen einer Statusmeldung an mindestens einen Teil der anderen autonomen technischen Systeme und/oder die gemeinsame Bewertung der Statusmeldung über eine sichere Datenverbindung und/oder nach einer gegenseitigen Identifizierung der Kommunikationspartner erfolgen. Beispielsweise kann eine Statusmeldung kryptografisch geschützt übermittelt werden. Ebenso kann eine Kontrollvorschrift vorzugsweise kryptografisch verschlüsselt über das Kommunikationsnetzwerk an ein Kontrollmodul übermittelt und erst dort entschlüsselt werden. Eine kryptografisch verschlüsselte Datenübertragung kann insbesondere Manipulationen verhindern. Für eine sichere Kommunikation können die teilnehmenden autonomen technischen Systeme insbesondere sich gegenseitig identifizieren und gegebenenfalls authentifizieren.

In einer weiteren vorteilhaften Ausführungsform des Verfahrens können mehrere autonome technische Systeme als überwachende autonome technische Systeme ausgebildet sein und es kann jedes dieser überwachenden autonomen Systeme eine Statusmeldung an andere autonomen technische Systeme übertragen und eine gemeinsame Bewertung der Statusmeldung erfolgen.

Insbesondere kann die Überwachung und/oder Bewertung lediglich von einem Teil der autonomen technischen Systeme ausgeführt werden. Die autonomen technischen Systeme können sich insbesondere gegenseitig überwachen und kontrollieren. Ein Teil der überwachenden Systeme kann auch ein Kontrollmodul umfassen. Jedes der überwachenden autonomen technischen Systeme kann insbesondere eine eigene Statusmeldung generieren und diese über das Kommunikationsnetzwerk mit den anderen autonomen technischen Systemen teilen. Um eine Kontrollvorschrift für ein sich regelwidrig verhaltendes System ableiten zu können, kann eine Bewertung aller über das Kommunikationsnetzwerk untereinander geteilten Statusmeldungen zu dessen Betriebsverhalten gemeinsam evaluiert werden. Es kann beispielsweise eine Mehrheitsentscheidung der Statusmeldungen erfolgen.

In einer weiteren vorteilhaften Ausführungsform des Verfahrens kann die Überwachung und/oder die Bewertung einer Statusmeldung und/oder das Steuern anhand einer Kontrollvorschrift mindestens eines autonomen technischen Systems fortlaufend und/oder zu vorgegebenen Zeitpunkten durchgeführt werden.

Es kann vorteilhaft sein, dass beispielsweise die Überwachung durch mindestens ein überwachendes autonomes technisches System fortlaufend und/oder zu vorgegebenen Zeitpunkten durchgeführt wird. Beispielsweise kann eine Überwachung eines der autonomen technischen Systeme durch abwechselnde Beobachtung dessen Betriebsverhaltens durch mehrere, sich abwechselnde, andere autonome technische Systeme erfolgen. Somit kann beispielsweise eine lückenlose und/oder zu vorgegebenen Zeitpunkten erforderliche Überprüfung eines Betriebsstatus und/oder Betriebsverhaltens eines autonomen technischen Systems erreicht werden. Sobald ein regelwidriges Betriebsverhalten detektiert wird, kann eine Statusmeldung darüber generiert und gemeinsam bewertet werden. Insbesondere kann ein durchgehendes Überwachen durch verschiedene autonome technische Systeme die Bewertung einer Statusmeldung erleichtern, wenn für die Bewertung eine Vielzahl an Daten von Sensoren zur Verfügung steht.

In einer weiteren vorteilhaften Ausführungsform des Verfahrens kann jedem autonomen technischen System, dass eine Statusmeldung bewertet, eine Gewichtung zugeordnet werden und damit die gemeinsame Bewertung einer Statusmeldung aus gewichteten Bewertungen bestimmt werden.

Eine einzelne Gewichtung kann insbesondere einen Anteil an einer Mehrheitsentscheidung über eine oder mehrere Statusmeldungen angeben. Beispielsweise kann ein autonomes technisches System eine vorgegebene Gewichtung haben, z.B. eine Wertzahl, die von einer offiziellen Stelle vorgegeben werden kann. Es kann eine Gewichtung auch anhand einer Anzahl, Qualität und/oder Position von Sensoren eines überwachenden autonomen technischen Systems bestimmt werden. Beispielsweise kann eine Statusmeldung über ein regelwidriges Betriebsverhalten von einem autonomen technischen System, das aufgrund einer Vielzahl von Sensoren eine höhere Gewichtung hat, überprüft werden.

In einer weiteren vorteilhaften Ausführungsform des Verfahrens kann die Gewichtung abhängig von einer Überwachungsgüte und/oder von einem Rang eines autonomen technischen Systems dynamisch angepasst werden.

Vorzugsweise kann autonomen technischen Systemen eine gleiche Gewichtung zugeordnet sein, wobei z.B. nach einer Zustandsänderung, wie z.B. durch Bewegung, für eines dieser Systeme die Gewichtung dynamisch angepasst werden kann. Beispielsweise kann eine Überwachungsgüte von der Positionierung, vom Blickwinkel oder vom Blickfeld der jeweiligen Sensoren abhängig sein, wobei sich die Überwachungsgüte mit einer Bewegung des Systems ändern kann. Die Gewichtung kann vom Rang, wie z.B. von einem Status, einer Klasse, einer Funktion, einer Hierarchiestufe oder einer vorgegebenen Bedeutung des technischen Systems abhängig sein. Eine dynamische Anpassung der Gewichtung kann beispielsweise eine Bewertung vertrauenswürdiger gestalten. Vorzugsweise kann die dynamische Anpassung der Gewichtung von einem autonomen technischen System selbst durchgeführt werden.

In einer weiteren vorteilhaften Ausführungsform des Verfahrens kann von einem überwachenden autonomen technischen System eine computergestützte Simulation eines Betriebsverhaltens eines anderen autonomen technischen Systems, basierend auf Sensordaten des überwachenden autonomen technischen Systems und/oder auf Sensordaten anderer überwachende autonomer technischer Systeme, durchgeführt werden und anhand der Simulation kann eine Vorhersage über ein zukünftiges Betriebsverhalten abgeleitet und als Statusmeldung an mindestens einen Teil der autonomen technischen Systeme übertragen werden.

Anhand der Sensordaten und mittels einer computergestützten Simulation kann eine Vorhersage über ein Betriebsverhalten eines überwachten autonomen technischen Systems generiert werden. Dazu kann beispielsweise ein Simulationsmodell der Umgebung des überwachenden autonomen technischen Systems bereitgestellt werden. Mittels aktueller Sensordaten der Umgebung und eines Simulationsmodells des überwachten autonomen Systems kann eine Betriebsweise und/oder Situation simuliert werden. Dies erleichtert vorzugsweise eine Überwachung des Betriebsverhaltens. Beispielsweise kann anhand von Geschwindigkeits- und Beschleunigungsdaten eine Fahrweise und Richtung eines autonomen technischen Systems extrapoliert werden.

In einer weiteren vorteilhaften Ausführungsform des Verfahrens kann anhand der computergestützten Simulation und einer vorgegebenen zweiten Regel ein zukünftiges, regelwidriges Betriebsverhalten detektiert werden, daraus kann eine Statusmeldung generiert werden und es kann diese Statusmeldung an mindestens einen Teil der autonomen technischen Systeme übertragen werden.

Insbesondere kann aus einer computergestützten Simulation, eine Vorhersage eines Betriebsverhaltens generiert und daraus, bei der Vorhersage eines regelwidrigen zukünftigen Betriebsverhaltens, eine Warnung als Statusmeldung ausgegeben werden. Das regelwidrige Betriebsverhalten kann anhand einer zweiten Regel, die insbesondere gleich der ersten Regel ausgebildet sein kann, ermittelt werden. Es kann nach der gemeinsamen Bewertung der Statusmeldung eine Kontrollvorschrift abgeleitet werden, die z.B. eine frühzeitige Abschaltung bewirkt, um einen Unfall zu vermeiden. Zur Simulation kann dazu beispielsweise eine Wahrscheinlichkeitsangabe zu einer Vorhersage generiert und ausgegeben werden. Des Weiteren kann beispielsweise mittels einer Simulation eine alternative Betriebsweise ermittelt und davon abhängig eine Statusmeldung generiert werden.

In einer weiteren vorteilhaften Ausführungsform des Verfahrens kann ein nicht-autonomes technisches System, das mit dem Kommunikationsnetzwerk verbunden ist,
- von mindestens einem überwachenden autonomen technischen System das Betriebsverhalten des nicht-autonomen technischen Systems überwacht und anhand einer vorgegebenen dritten Regel ein regelwidriges Betriebsverhalten des nicht-autonomen technischen Systems detektiert werden,
- eine Statusmeldung von mindestens einem Teil der anderen autonomen technischen Systeme bewertet und daraus eine Kontrollvorschrift für das nicht-autonome technische System abgeleitet werden,
   und
- das Betriebsverhalten des nicht-autonomen technischen Systems mittels einer Kontrollvorschrift von einem, dem nicht-autonomen technischen System zugeordneten, Kontrollmodul kontrolliert werden.

Insbesondere kann das Kommunikationsnetzwerk, über das die autonomen technischen Systeme vernetzt sind, um nicht-autonome technische Systeme erweitert werden. Ein nicht-autonomes technisches System kann beispielsweise mit einem Kontrollmodul ausgestattet sein, welches eine externe Steuerung durch eine von der Vielzahl autonomer technischer Systeme bewerteten Kontrollvorschrift ermöglicht. So kann die Vielzahl an überwachenden autonomen technischen Systemen beispielsweise einen externen und gemeinsam kontrollierten Zugriff auf ein nicht-autonomes technisches System haben, wenn dieses regelwidrig gesteuert wird. Eine vorgegebene dritte Regel kann insbesondere gleich einer vorgegebenen ersten und/oder einer vorgegebenen zweiten Regel sein.

Ein weiterer Aspekt der Erfindung betrifft eine Vorrichtung zur gegenseitigen Überwachung und Kontrolle einer Vielzahl autonomer technischer Systeme, welche zumindest teilweise untereinander über ein Kommunikationsnetzwerk vernetzt sind, die derart eingerichtet ist, die Schritte eines erfindungsgemäßen Verfahrens durchzuführen, umfassend mindestens ein Überwachungsmodul eines autonomen technischen Systems und mindestens ein Kontrollmodul, das einem anderen autonomen technischen System zugeordnet ist.

Es ist ein Vorteil der Erfindung, dass autonome technische Systeme untereinander derart vernetzt sind, dass sie sich gegenseitig überwachen und bei einer Regelverletzung gegenseitig in einen sicheren Zustand versetzen können. Insbesondere umfasst die erfindungsgemäße Vorrichtung mindestens ein Überwachungsmodul, das einem autonomen technischen System zugeordnet ist und das derart eingerichtet ist, mindestens ein anderes autonomes technisches System beispielsweise mittels mindestens eines Sensors zu überwachen. Ein Kontrollmodul eines autonomen technischen Systems kann insbesondere derart eingerichtet sein, dass es eine Kontrollvorschrift empfängt und anhand der Kontrollvorschrift ein Betriebsverhalten des autonomen technischen Systems steuern kann.

In einer vorteilhaften Ausführungsform der Vorrichtung kann mindestens ein Teil der autonomen technischen Systeme als überwachende autonome technische Systeme, umfassend jeweils ein Überwachungsmodul und mindestens einen Sensor, ausgestaltet sein und mindestens ein Teil der autonomen technischen Systeme kann jeweils ein Kontrollmodul umfassen, wobei mindestens ein Teil der Überwachungsmodule und mindestens ein Teil der Kontrollmodule über das Kommunikationsnetzwerk untereinander verbunden sind.

Vorzugsweise können autonome technische Systeme mit einem Überwachungsmodul und einem Kontrollmodul ausgestattet sein, um beispielsweise eine gegenseitige Überwachung und Kontrolle zu ermöglichen. Insbesondere können Infrastruktursensoren, wie z.B. Ampeln oder Schranken, als rein überwachende autonome Systeme verstanden werden. Zu gemeinsamen und gegenseitigen Kontrolle können die Überwachungsmodule und Kontrollmodule über ein drahtloses oder drahtgebundenes Kommunikationsnetzwerk miteinander verbunden sein. So kann eine gemeinsame Bewertung einer Statusmeldung erfolgen.

In einer vorteilhaften Ausführungsform der Vorrichtung kann ein Kontrollmodul eine erste Kommunikationsschnittstelle zum Kommunikationsnetzwerk zum Empfangen und Entschlüsseln einer verschlüsselten Datenübertragung umfassen.

Insbesondere kann ein Kontrollmodul derart ausgestaltet sein, dass eine verschlüsselte Kontrollvorschrift lediglich vom Kontrollmodul entschlüsselt werden kann. Dies kann beispielsweise eine Manipulation der Kontrollvorschrift bei der Übermittlung verhindern.

In einer vorteilhaften Ausführungsform der Vorrichtung kann ein Überwachungsmodul eine Bewertungseinheit zum Bewerten einer von der Bewertungseinheit generierten und/oder empfangenen Statusmeldung umfassen.

Eine Bewertungseinheit kann insbesondere derart eingerichtet sein, dass es eine von einem anderen autonomen technischen System übermittelte Statusmeldung empfangen und diese bewerten kann. Beispielsweise kann die Bewertungseinheit anhand vorgegebener Bewertungskriterien, wie zum Beispiel eine Qualität der Detektion einer regelwidrigen Betriebsweise, und/oder der vorgegebenen ersten Regel eine Statusmeldung evaluieren. Die Bewertungseinheit kann insbesondere abstimmen, ob eine Kontrollvorschrift zum Steuern eines anderen autonomen Systems abgeleitet und diesem übermittelt werden soll. Vorzugsweise kann eine dem überwachenden autonomen technischen System zugeordnete Gewichtung in der Bewertungseinheit gespeichert sein und/oder dort dynamisch angepasst werden. Die Bewertung einer Bewertungseinheit kann über das Kommunikationsnetzwerk den anderen autonomen technischen Systemen bereitgestellt und eine gemeinsame Bewertung kann daraus abgeleitet werden.

In einer vorteilhaften Ausführungsform der Vorrichtung kann ein Überwachungsmodul eine zweite Kommunikationsschnittstelle zum Kommunikationsnetzwerk zum verschlüsselten Übertragen von Daten und Entschlüsseln von verschlüsselten Daten umfassen.

Insbesondere kann ein Überwachungsmodul eine Statusmeldung kryptografisch verschlüsseln und diese an andere autonome technische Systeme zur Bewertung übertragen.

In einer vorteilhaften Ausführungsform der Vorrichtung kann ein Überwachungsmodul eine Simulationseinheit zum Simulieren eines Betriebsverhaltens eines anderen autonomen technischen Systems, basierend auf Sensordaten des überwachenden autonomen technischen Systems und/oder auf Sensordaten anderer überwachende autonomer technischer Systeme umfassen.

Die Simulationseinheit kann insbesondere ein Simulationsmodell der Umgebung des überwachenden autonomen technischen Systems umfassen, welches mittels aktueller Sensordaten angepasst werden kann.

Des Weiteren umfasst die Erfindung ein Computerprogrammprodukt, das direkt in einen programmierbaren Computer ladbar ist, umfassend Programmcodeteile, die dazu geeignet sind, und die Schritte eines erfindungsgemäßen Verfahrens durchzuführen.

Ausführungsbeispiele des erfindungsgemäßen Verfahrens und Vorrichtung sind in den Zeichnungen beispielhaft dargestellt und werden anhand der nachfolgenden Beschreibung näher erläutert. Es zeigen:
- Fig. 1: ein Ablaufdiagramm eines erfindungsgemäßen Verfahrens;
- Fig. 2: eine schematische Darstellung eines erfindungsgemäßen Verfahrens;
- Fig. 3: eine weitere schematische Darstellung eines erfindungsgemäßen Verfahrens;
- Fig. 4: eine weitere schematische Darstellung eines erfindungsgemäßen Verfahrens;
- Fig. 5: eine weitere schematische Darstellung eines erfindungsgemäßen Verfahrens; und
- Fig. 6: eine schematische Darstellung einer erfindungsgemäßen Vorrichtung.

Einander entsprechende Gegenstände sind in allen Figuren mit den gleichen Bezugszeichen versehen.

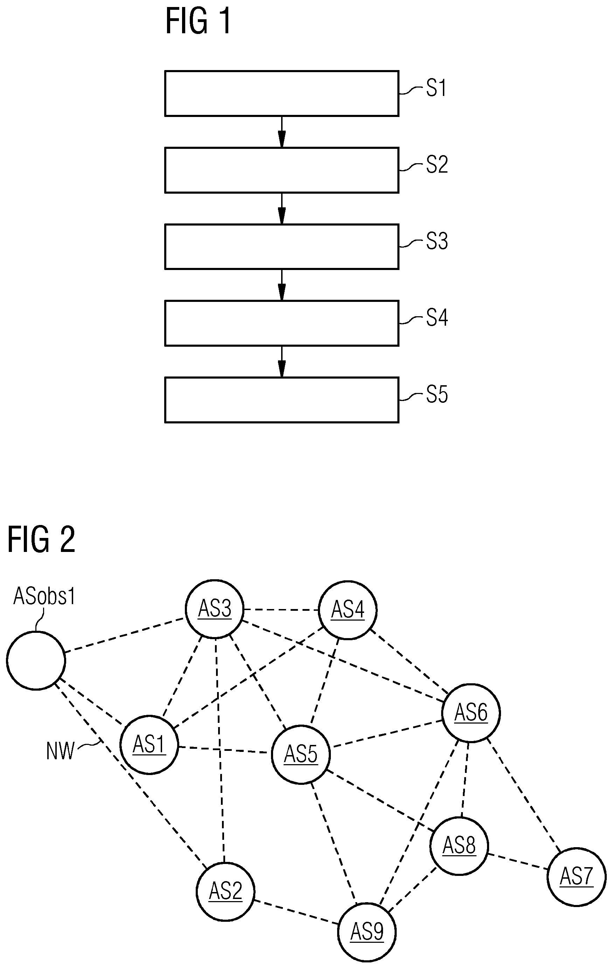

Figur 1 zeigt ein Ablaufdiagramm eines erfindungsgemäßen Verfahrens zur gegenseitigen Überwachung und/oder Kontrolle einer Vielzahl autonomer technischer Systeme, die zumindest teilweise untereinander über ein Kommunikationsnetzwerk vernetzt sind. Mindestens eines der autonomen technischen Systeme ist als ein überwachendes autonomes technisches System ausgebildet, d. h. es umfasst mindestens einen Sensor und ein Überwachungsmodul zum Überwachen mindestens eines der anderen autonomen technischen Systeme. Vorzugsweise ist das überwachte autonome technische System mit einem Kontrollmodul ausgestattet oder es ist diesem ein Kontrollmodul zugeordnet. Insbesondere kann unter gegenseitiger Überwachung und/oder Kontrolle einer Vielzahl autonomer technischer Systeme eine Überwachung und/oder Kontrolle von mindestens einem der Systeme verstanden werden, wobei mindestens ein anderes der autonomen technischen Systeme kontrolliert wird, aber beispielsweise auch selbst andere autonome technische Systeme überwachen kann.

In Schritt S1 des Verfahrens überwacht das überwachende autonome technische System ein Betriebsverhalten eines anderen autonomen technischen Systems. Beispielsweise umfasst das überwachende autonome technische System eine Kamera als Sensor und zeichnet damit einen zeitlichen Verlauf des Betriebs- verhaltens, wie z.B. einen Geschwindigkeitsverlauf, des ande- ren autonomen technischen Systems auf.

Anhand einer vorgegebenen ersten Regel kann das überwachende autonome technische System in Schritt S2 überprüfen, ob das andere autonome technische System sich regelwidrig verhält, z.B. eine Geschwindigkeitsbegrenzung überschreitet. Wenn das überwachende autonome technische System ein regelwidriges Betriebsverhalten des anderen autonomen technischen Systems detektiert, kann es eine Statusmeldung über dieses regelwidrige Betriebsverhalten generieren. Die Statusmeldung kann insbesondere anhand der Detektion des regelwidrigen Betriebsverhaltens durch den Sensor vom Überwachungsmodul generiert werden. Vorzugsweise übertragt der Sensor eine Überwachungsinformation an das Überwachungsmodul des überwachenden autonomen technischen Systems. Die Statusmeldung umfasst eine Identifizierungsinformation des überwachten autonomen technischen Systems und Angaben über das Betriebsverhalten.

In Schritt S3 kann die Statusmeldung vom überwachenden autonomen technischen System an mindestens einen Teil der Vielzahl autonomer technischer Systeme, die über das Kommunikationsnetzwerk miteinander vernetzt sind, übertragen werden. Insbesondere kann lediglich ein Teil der autonomen technischen Systeme als Empfänger der Statusmeldung ausgewählt werden. Vorzugsweise kann jedes der autonomen technischen Systeme ein Überwachungsmodul umfassen, wobei das Überwachungsmodul nicht aktiv für eine Überwachung eingeschalten sein muss, sondern lediglich Statusmeldungen anderer Systeme empfangen kann.

In Schritt S4 empfängt der eine Teil der autonomen technischen Systeme die Statusmeldung und bewertet diese. Eine Bewertung erfolgt vorzugsweise jeweils in einer Bewertungseinheit eines Überwachungsmoduls. Erfindungsgemäß wird eine gemeinsame Bewertung der Statusmeldung basierend auf den einzelnen Bewertungen durchgeführt. Die Bewertung ist eine Mehrheitsentscheidung oder eine gewichtete Bewertung. Eine Gewichtung ist jeweils einem autonomen technischen System zugeordnet. Abhängig von der Bewertung der Statusmeldung wird eine Kontrollvorschrift für das erste autonome technische System abgeleitet. Zum Beispiel kann eine Statusmeldung über eine Geschwindigkeitsüberschreitung eines autonomen technischen Systems von dem einen Teil der autonomen technischen Systeme überprüft oder bewertet werden. Abhängig von der Überprüfung oder Bewertung kann daraus eine Kontrollvorschrift, wie zum Beispiel eine Begrenzung der Geschwindigkeit, abgeleitet werden.

Beispielsweise kann die Kontrollvorschrift in einem Überwachungsmodul erstellt werden. Beispielsweise kann die Kontrollvorschrift abhängig von Vorgaben einer staatlichen Stelle oder eines Herstellers oder gemäß Sicherheitsbestimmungen abgeleitet werden.

In Schritt S5 wird die Kontrollvorschrift über das Kommunikationsnetzwerk an das sich regelwidrig verhaltende autonome technische System übertragen. Insbesondere wird die Kontrollvorschrift an ein Kontrollmodul, das dem sich regelwidrig verhaltenden autonomen technischen System zugeordnet ist, übertragen. Die Übertragung erfolgt vorzugsweise über das Kommunikationsnetzwerk der autonomen technischen Systeme und kann beispielsweise kryptografisch verschlüsselt und lediglich im Kontrollmodul entschlüsselbar sein. Die Kontrollvorschrift kann von einem beliebigen, an der Bewertung teilnehmenden, autonomen technischen System gesendet werden. Vorzugsweise erfolgt vor der Übertragung der Kontrollvorschrift eine gegenseitige Identifizierung und/oder Authentifizierung der beiden autonomen technischen Systeme. Anhand der Kontrollvorschrift kann das Betriebsverhalten des ersten autonomen technischen Systems vom Kontrollmodul kontrolliert bzw. gesteuert werden. Die Kontrollvorschrift kann zum Beispiel einen Befehl für einen Bremsvorgang umfassen, der direkt ausgeführt werden soll, d.h. ein aktueller Steuerungsbefehl für das autonome technische System kann beispielsweise von der Kontrollvorschrift überschrieben oder geändert werden.

Figur 2 zeigt in schematischer Darstellung ein Ausführungsbeispiel des erfindungsgemäßen Verfahrens und einer erfindungsgemäßen Vorrichtung. Es ist ein Kommunikationsnetzwerk NW gezeigt, welches drahtlos und/oder drahtgebunden ausgebildet sein kann. Eine Vielzahl autonomer technischer Systeme, AS1 bis AS9, ist über das Kommunikationsnetzwerk NW miteinander vernetzt, wobei mindestens ein autonomes technisches System ASobs1 als ein überwachendes autonomes technisches System ausgebildet ist. Insbesondere umfasst das überwachende autonome technische System ASobs1 mindestens einen Sensor, der aktiv ein Betriebsverhalten mindestens eines der anderen autonomen technischen Systeme, AS1 bis AS9, überwacht und Sensordaten an ein Überwachungsmodul übermittelt.

Das Kommunikationsnetzwerk NW dient insbesondere zur Kommunikation der autonomen und nicht-autonomen technischen Systeme untereinander, wie z.B. zum Übermitteln von Statusmeldungen zur gemeinsamen Bewertung. Die Überwachung eines technischen Systems durch ein überwachendes autonomes technisches System ASobs1 ist insbesondere unabhängig von einer direkten Verbindung über das Kommunikationsnetzwerk, d.h. eine Überwachung eines anderen technischen Systems kann insbesondere auch erfolgen, wenn keine direkte Kommunikationsverbindung zwischen dem überwachenden und dem überwachten autonomen technischen System vorliegt.

Das überwachende autonome technische System Asobs1 kann beispielsweise das Betriebsverhalten eines ersten autonomen technischen Systems AS1 überwachen und anhand einer ersten Regel ein regelwidriges Betriebsverhalten detektieren. Beispielsweise umfasst eine erste Regel eine Geschwindigkeitsbegrenzung, eine Fahrbahnbegrenzung oder einen limitierten Aktionsradius. Insbesondere kann die erste Regel von einer offiziellen Stelle, wie z.B. von einer Behörde oder einer zentralen Steuereinheit, vorgegeben sein. Das überwachende autonome technische System Asobs1 stellt eine Statusmeldung über das regelwidrige Betriebsverhalten des ersten autonomen technischen Systems AS1 aus und übermittelt die Statusmeldung an mindestens einen Teil der anderen autonomen technischen Systeme AS2 bis AS9. Die Statusmeldung kann auch allen oder einem Teil der anderen autonomen technischen Systeme AS2 bis AS9 über das Kommunikationsnetzwerk NW bereitgestellt werden, wie z.B. über einen Server.

Die Statusmeldung kann beispielsweise eine Angabe über ein regelwidriges Betriebsverhalten, Angaben zur Position und gegebenenfalls Angaben über ein zukünftiges Betriebsverhalten, welches mittels einer computergestützten Simulation bestimmt wurde, umfassen.

Die Statusmeldung wird gemeinsam von den anderen autonomen technischen Systemen bewertet. Insbesondere kann lediglich ein Teil der anderen technischen Systeme, die die Statusmeldung empfangen haben, eine Bewertung durchführen. Erfindungsgemäß wird eine Kontrollvorschrift aus der Statusmeldung abgeleitet, wenn zum Beispiel die gemeinsame Bewertung durch mindestens einen Teil der anderen autonomen technischen Systeme ergibt, dass die Statusmeldung gültig ist. Abhängig von der gemeinsamen Bewertung der Statusmeldung wird eine Kontrollvorschrift ausgestellt und an das erste autonome technische System AS1 übermittelt. Das erste autonome technische System AS1 umfasst vorzugsweise ein Kontrollmodul, an das die Kontrollvorschrift gesendet werden kann und das, abhängig von Befehlen der Kontrollvorschrift, das erste autonome technische System AS1 steuert. Das erste autonome technische System AS1 kann somit von extern durch eine Kontrollvorschrift, die von einer Vielzahl autonomer technischer Systeme genehmigt wurde, kontrolliert werden.

Die Überwachung durch das überwachende autonome technische System ASobs1 kann beispielsweise fortlaufend oder zu vorgegebenen Zeitpunkten erfolgen. Beispielsweise kann das überwachende autonome technische System mindestens einen Sensor umfassen, wie zum Beispiel eine Kamera, die fortlaufend die Umgebung des autonomen technischen Systems aufzeichnet. Des Weiteren kann die Bewertung einer Statusmeldung durch mindestens einen Teil der anderen autonomen technischen Systeme AS2 bis AS9 fortlaufend oder zu vorgegebenen Zeitpunkten erfolgen. So kann das Kontrollieren oder Steuern eines sich regelwidrig verhaltenden autonomen technischen Systems ebenso fortlaufend oder zu vorgegebenen Zeitpunkten durchgeführt werden. Beispielsweise kann ein vorgegebener Zeitpunkt die Detektion eines regelwidrigen Betriebsverhaltens sein.

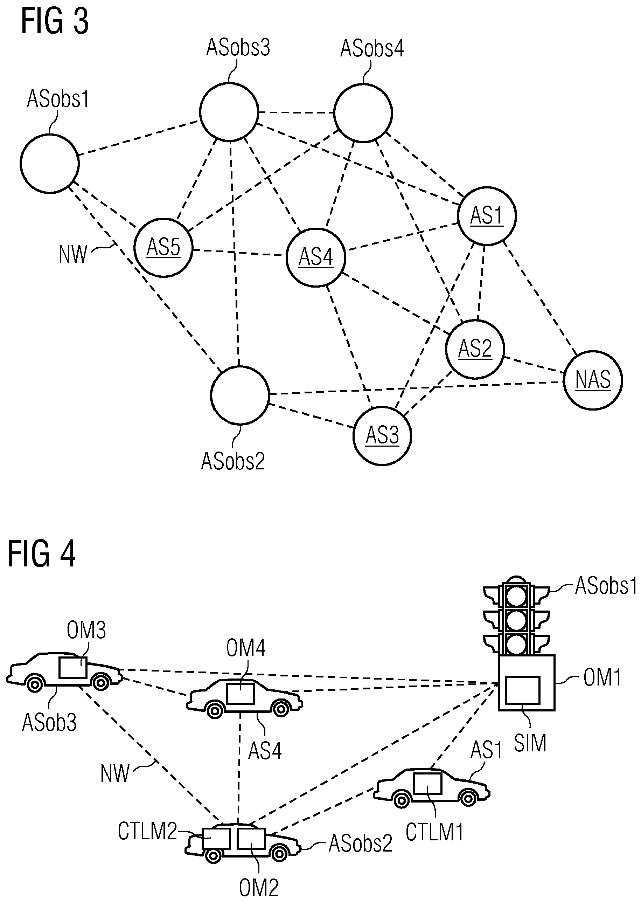

Figur 3 zeigt ein Kommunikationsnetzwerk NW, über welches mehrere autonome technische Systeme, AS1 bis AS5, und mehrere überwachende autonome technische Systeme, ASobs1 bis ASobs4, und ein nicht-autonomes technisches System NAS miteinander vernetzt sind. Jedes der überwachenden autonomen technischen Systeme umfasst mindestens einen Sensor und ein Überwachungsmodul. Jedes der autonomen technischen Systeme kann ebenso Sensoren und ein Überwachungsmodul umfassen, wobei ein autonomes technisches System nicht überwachend tätig sein kann, d.h. das Überwachungsmodul und/oder ein Sensor kann inaktiv sein. Insbesondere kann jedes der autonomen technischen Systeme ein Kontrollmodul umfassen, so dass bei einem regelwidrigen Betriebsverhalten eine externe Kontrolle gemäß der Erfindung möglich ist.

Jedes der überwachenden autonomen technischen Systeme ASobs1 bis ASobs4 kann, unabhängig von den anderen, jedes der anderen autonomen technischen Systeme ASobs1 bis ASobs4, AS1 bis AS5 überwachen und anhand einer ersten vorgegebenen Regel überprüfen ob eines sich regelwidrig verhält. Jedes der überwachenden autonomen technischen Systeme kann eine Statusmeldung über ein regelwidriges Betriebsverhalten eines anderen autonomen technischen Systems generieren und den jeweils anderen autonomen technischen Systemen zur Bewertung übermittelt werden. Insbesondere kann eine gemeinsame Bewertung der Statusmeldungen erfolgen, wenn diese z.B. dasselbe autonome technische System betreffen. Beispielsweise kann jedem der überwachenden autonomen technischen Systeme eine Gewichtung zugeordnet sein, die beispielsweise abhängig von der Position eines überwachenden Sensors ist. Die gemeinsame Bewertung einer oder mehrerer Statusmeldungen kann abhängig von der Gewichtung durchgeführt werden. Die Gewichtung kann insbesondere vorgegeben sein, wie z.B. abhängig von einem Rang, wie z.B. Verkehrswacht, oder durch eine offizielle Stelle, oder dynamisch angepasst werden, wenn sich beispielsweise die Überwachungsgüte aufgrund von Umgebungsbedingungen ändern. Ein Rang kann beispielsweise eine Hierarchiestufe beschreiben, wie z.B. bei Fahrzeugen ein Polizeiwagen, ein Feuerwehreinsatzfahrzeug oder Rettungswagen.

Das nicht-autonome technische System NAS kann insbesondere ein Kontrollmodul gemäß der Erfindung umfassen, oder ein Kontrollmodul kann diesem zugeordnet sein, und damit an das Kommunikationsnetzwerk NW angeschlossen sein. Die überwachenden autonomen technischen Systeme können die Überwachung und Kontrolle des nicht-autonomen technischen Systems NAS übernehmen, wobei lediglich das Kontrollmodul des nicht-autonomen technischen Systems NAS derart ausgestaltet sein muss, dass von extern Kontrollvorschriften übermittelt und umgesetzt werden können.

Figur 4 zeigt beispielhaft ein Szenario des erfindungsgemäßen Verfahrens. Es ist ein erstes autonomes technisches System ASobs1 als eine Anlage zur Verkehrsregelung gezeigt, welche ein erstes Überwachungsmodul OM1 umfasst. Beispielsweise ist das erste Überwachungsmodul OM1 eine Kamera oder ein Geschwindigkeitssensor.

Des Weiteren sind autonome Fahrzeuge AS1, ASobs2, ASobs3 und AS4 gezeigt. Das erste autonome Fahrzeug AS1 umfasst lediglich ein erstes Kontrollmodul CTLM1. Das zweite autonome Fahrzeug ASobs2 ist als ein überwachendes autonomes Fahrzeug ausgebildet und umfasst ein zweites Überwachungsmodul CTLM2 und mindestens einen Sensor. Außerdem umfasst das zweite autonome Fahrzeug ASobs2 ein zweites Kontrollmodul CTLM2. Das dritte autonome Fahrzeug ASobs3 ist ebenso als überwachendes autonomes Fahrzeug ausgebildet und umfasst ein drittes Überwachungsmodul OM3. Das vierte autonome Fahrzeug AS4 umfasst ein viertes Überwachungsmodul OM4, welches beispielsweise inaktiv sein kann, d.h. das vierte autonome Fahrzeug kann nicht aktiv andere autonome technische Systeme überwachen, aber beispielsweise an einer Bewertung einer Statusmeldung teilnehmen. Die autonomen Fahrzeuge sind über ein Kommunikationsnetzwerk NW untereinander verbunden. Insbesondere umfassen die Überwachungsmodule OM1 bis OM4 jeweils eine Bewertungseinheit zum Bewerten einer über das Kommunikationsnetzwerk NW geteilten Statusmeldung.

Im gezeigten Ausführungsbeispiel kann das erste autonome Fahrzeug AS1 von mindestens einem der anderen autonomen Fahrzeuge und/oder der Anlage zur Verkehrsregelung überwacht werden. Beispielsweise kann die Anlage zur Verkehrsregelung ASobs1 anhand einer Geschwindigkeitsmessung und einer ersten Regel überprüfen, ob sich das erste autonome Fahrzeug AS4 regelkonform verhält. Beispielsweise kann die Anlage zur Verkehrsregelung ASobs1 anhand einer Geschwindigkeitsmessung für das erste autonome Fahrzeug AS1 ermitteln, dass dieses eine Geschwindigkeitsbegrenzung überschreitet.

Insbesondere kann das erste Überwachungsmodul OM1 eine Simulationseinheit SIM umfassen und mittels einer computergestützten Simulation eine Vorhersage über das Betriebsverhalten des ersten autonomen Fahrzeugs AS1 ermitteln. Die Anlage zur Verkehrsregelung ASobs1 kann beispielsweise anhand der Simulation extrapolieren, ob das erste autonome Fahrzeug AS1 zu einem vorgegebenen Zeitpunkt zum Halten kommen kann.

Die Anlage zur Verkehrsregelung ASobs1 kann anhand dieser Überwachungsergebnisse eine Statusmeldung über das Betriebsverhalten des ersten autonomen Fahrzeugs AS1 generieren und über das Kommunikationsnetzwerk den anderen autonomen Fahrzeugen ASobs2, ASobs3, AS4 übermitteln.

Die anderen autonomen Fahrzeuge ASobs2, ASobs3, AS4 können die Statusmeldung empfangen und in der jeweiligen Bewertungseinheit des jeweiligen Überwachungsmoduls OM2, OM3, OM4 bewerten. Beispielsweise kann das zweite überwachende autonome Fahrzeug ASobs2 die Statusmeldung der Anlage für Verkehrsregelung Asobs1 anhand eigener Überwachungsdaten überprüfen und anschließend bewerten. Es kann außerdem eine Bewertung anhand von Informationen aus der Statusmeldung selbst, wie z.B. Angaben zu Messunsicherheiten, erfolgen.

Abhängig von der gemeinsamen Bewertung durch mindestens einen Teil der anderen autonomen Fahrzeuge ASobs2, ASobs3, AS4 kann eine Kontrollvorschrift abgeleitet werden. Beispielsweise kann die Statusmeldung mittels einer Mehrheitsentscheidung für gültig erklärt werden. Anhand der Geschwindigkeitsprognose durch die Simulation kann beispielsweise ein Befehl zum Abbremsen zu einem bestimmten Zeitpunkt bestimmt werden.

Die abgeleitete Kontrollvorschrift wird dem Kontrollmodul CTLM1 des ersten autonomen Fahrzeugs AS1 übermittelt. Es erfolgt eine Kontrolle bzw. Steuerung des ersten autonomen Fahrzeugs AS1 von extern, abhängig von den Steuerbefehlen der Kontrollvorschrift. Das erste autonome Fahrzeug AS1 kann beispielsweise gestoppt, abgeschaltet oder abgebremst werden.

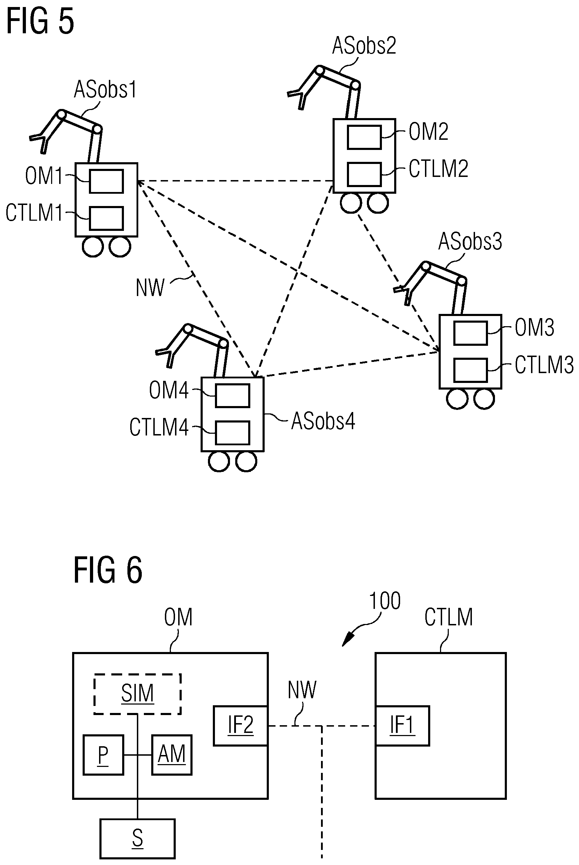

Figur 5 zeigt ein weiteres Ausführungsbeispiel eines erfindungsgemäßen Verfahrens. Es sind autonome Roboter, wie z.B. mobile Industrieroboter, als autonome technische Systeme ASobs1 bis ASobs4 gezeigt. Die Roboter ASobs1 bis ASobs4 sind jeweils als überwachende autonome technische Systeme ausgestaltet. Sie sind über das Kommunikationsnetzwerk NW miteinander vernetzt. Mittels der Überwachungsmodule OM1 bis OM4 können die überwachenden autonomen technischen Systeme ASobs1 bis ASobs4 untereinander das jeweilige Betriebsverhalten überwachen. Es kann beispielsweise ein regelwidriges Betriebsverhalten eines der autonomen technischen Systeme ASobs1 bis ASobs4 durch mindestens eines der anderen autonomen technischen Systeme detektiert werden. Beispielsweise kann durch eine Manipulation oder durch eine Fehlfunktion ein Roboter ASobs4 eine regelwidrige Aktion durchführen, wie z.B. einen vordefinierten Betriebsradius bei einer Mensch-Roboter-Interaktion nicht einhalten. Gemäß der Erfindung kann eine Statusmeldung über das regelwidrige Betriebsverhalten des Roboters ASobs4 über das Kommunikationsnetzwerk NW an andere vernetzte Roboter ASobs1 bis ASobs3 übermittelt und von diesen gemeinsam bewertet werden. Abhängig von der Bewertung kann eine Kontrollvorschrift an das Kontrollmodul CTLM4 übermittelt und dort gemäß der Erfindung umgesetzt werden. Beispielsweise kann der Roboter ASobs4 abgeschaltet oder sein Aktionsradius beschränkt werden. Das gezeigte Verfahren kann insbesondere auch bei einer Mensch-Roboter-Interaktion genutzt werden, um beispielsweise eine Gefahr für den Menschen bei einer Fehlfunktion einer der autonomen Roboter ASobs1 bis ASobs4 zu verringern.

Figur 6 zeigt beispielhaft eine Ausführung einer erfindungsgemäßen Vorrichtung 100, umfassend mindestens ein Überwachungsmodul OM eines autonomen technischen Systems und ein Kontrollmodul CTLM eines anderen autonomen technischen Systems. Das Überwachungsmodul OM und das Kontrollmodul CTLM sind über das Kommunikationsnetzwerk NW miteinander verbunden.

Das Kontrollmodul und das Überwachungsmodul umfassen jeweils eine erste und zweite Kommunikationsschnittstelle IF1 und IF2, die eine kryptografisch verschlüsselte Datenübermittlung erlaubt. Beispielsweise kann das Überwachungsmodul OM eine verschlüsselte Statusmeldung an andere Überwachungsmodule übermitteln. Außerdem kann ein Überwachungsmodul OM eine verschlüsselte Kontrollvorschrift an das Kontrollmodul CTLM übermitteln, welche erst dort entschlüsselt werden kann.

Das Überwachungsmodul OM ist insbesondere mit mindestens einem Sensor S gekoppelt, wie z.B. fest verbunden oder per Funkverbindung zusammen geschaltet. Der Sensor S kann Sensordaten erfassen und diese an das Überwachungsmodul OM übermitteln. Anhand der Sensordaten und einer vorgegebenen ersten Regel kann das Überwachungsmodul OM ermitteln, ob z.B. ein regelwidriges Betriebsverhalten eines anderen autonomen technischen Systems vorliegt.

Das Überwachungsmodul OM umfasst des Weiteren eine Bewertungseinheit AM, vorzugsweise eine Simulationseinheit SIM und einen Prozessor P zum Durchführen mindestens einer der Schritte eines erfindungsgemäßen Verfahrens. Die Bewertungseinheit AM ist insbesondere dem autonomen technischen System zugeordnet und kann beispielsweise Informationen zur Gewichtung einer Bewertung umfassen.

Alle beschriebenen und/oder gezeichneten Merkmale können im Rahmen der Erfindung vorteilhaft miteinander kombiniert werden.

## Patentansprüche

1. Verfahren zur gegenseitigen Überwachung und/oder Kontrolle einer Vielzahl autonomer technischer Systeme, die zumindest teilweise untereinander über ein Kommunikationsnetzwerk (NW) vernetzt sind, wobei die autonomen technischen Systeme als autonome Fahrzeuge, Geräte oder Roboter ausgebildet sind, welche sich beispielsweise autonom bewegen oder selbsttätig agieren können, wobei:
- mindestens eines der autonomen technischen Systeme (AS1, AS2, AS3,...) als ein überwachendes autonomes technisches System (ASobs1) ausgebildet ist und das Betriebsverhalten anderer autonomer technischer Systeme überwacht (S1),
- vom überwachenden autonomen technischen System (ASobs1) anhand einer vorgegebenen ersten Regel ein regelwidriges Betriebsverhalten eines ersten autonomen technischen Systems (AS1) der autonomen technischen Systeme (AS1, AS2, AS3,...) detektiert und daraus eine Statusmeldung über das regelwidrige Betriebsverhalten des ersten autonomen technischen Systems (AS1) der autonomen technischen Systeme (AS1, AS2, AS3,...) generiert wird (S2),
- die Statusmeldung vom überwachenden autonomen technischen System (ASobs1) an einen Teil der anderen autonomen technischen Systeme übertragen wird (S3), wobei die Statusmeldung eine Identifizierungsinformation des ersten autonomen technischen Systems (AS1) und Angaben über das regelwidrige Betriebsverhalten umfasst,
- die Statusmeldung von dem Teil der anderen autonomen technischen Systeme empfangen und von diesen gemeinsam bewertet wird und, abhängig von der Bewertung, eine Kontrollvorschrift für das erste autonome technische System (AS1) der autonomen technischen Systeme (AS1, AS2, AS3,...) abgeleitet wird (S4), wobei ein Ergebnis der gemeinsamen Bewertung aus einer Mehrheitsentscheidung der anderen autonomen technischen Systeme oder aus gewichteten Bewertungen der anderen autonomen technischen Systeme ermittelt wird, und die Kontrollvorschrift basierend auf dem Ergebnis der gemeinsamen Bewertung abgeleitet wird
und
- die Kontrollvorschrift einem Kontrollmodul (CTLM), das dem ersten autonomen technischen System (AS1) der autonomen technischen Systeme (AS1, AS2, AS3,...) zugeordnet ist, übermittelt wird und das Betriebsverhalten des ersten autonomen technischen Systems (AS1) der autonomen technischen Systeme (AS1, AS2, AS3,...) anhand der Kontrollvorschrift vom Kontrollmodul (CTLM) gesteuert wird (S5).

2. Verfahren nach Anspruch 1, wobei ein überwachendes autonomes technisches System (ASobs1) mindestens einen Sensor (S) umfasst, der Sensor (S) Sensordaten erfasst und anhand der Sensordaten ein regelwidriges Betriebsverhalten eines der anderen autonomen technischen Systeme (AS1, AS2, AS3,...) detektiert wird.

3. Verfahren nach einem der vorhergehenden Ansprüche, wobei das Übertragen der Statusmeldung und/oder die gemeinsame Bewertung der Statusmeldung und/oder die Übermittlung der Kontrollvorschrift mittels einer verschlüsselten Datenübertragung über das Kommunikationsnetzwerk (NW) erfolgt.

4. Verfahren nach einem der vorhergehenden Ansprüche, wobei das Übertragen der Statusmeldung und/oder die gemeinsame Bewertung der Statusmeldung und/oder die Übermittlung der Kontrollvorschrift nach gegenseitiger Identifizierung der autonomen technischen Systeme untereinander erfolgt.

5. Verfahren nach einem der vorhergehenden Ansprüche, wobei mehrere autonome technische Systeme als überwachende autonome technische Systeme (ASobs1, ASobs2, ASobs3, ...) ausgebildet sind und jedes dieser überwachenden autonomen Systeme eine Statusmeldung an andere autonome technische Systeme (AS1, AS2, AS3,...) überträgt und eine gemeinsame Bewertung der Statusmeldungen erfolgt.

6. Verfahren nach einem der vorhergehenden Ansprüche, wobei die Überwachung und/oder die Bewertung einer Statusmeldung und/oder das Steuern anhand einer Kontrollvorschrift mindestens eines autonomen technischen Systems fortlaufend durchgeführt werden.

7. Verfahren nach einem der vorhergehenden Ansprüche, wobei die Überwachung und/oder die Bewertung einer Statusmeldung und/oder das Steuern anhand einer Kontrollvorschrift mindestens eines autonomen technischen Systems zu vorgegebenen Zeitpunkten durchgeführt werden.

8. Verfahren nach einem der vorhergehenden Ansprüche, wobei jedem autonomen technischen System, das eine Statusmeldung bewertet, eine Gewichtung zugeordnet wird und damit die gemeinsame Bewertung einer Statusmeldung aus gewichteten Bewertungen bestimmt wird.

9. Verfahren nach Anspruch 8, wobei die Gewichtung abhängig von einer Überwachungsgüte und/oder von einem Rang eines autonomen technischen Systems dynamisch angepasst wird.

10. Verfahren nach einem der vorhergehenden Ansprüche, wobei von einem überwachenden autonomen technischen System (ASobs1) eine computergestützte Simulation eines Betriebsverhaltens eines anderen autonomen technischen Systems (AS1, AS2, AS3, ...), basierend auf Sensordaten des überwachenden autonomen technischen Systems (ASobs1) und/oder auf Sensordaten anderer überwachender autonomer technischer Systeme (ASobs2, ASobs3, ASobs4, ...), durchgeführt wird und anhand der Simulation eine Vorhersage über ein zukünftiges Betriebsverhalten abgeleitet und als Statusmeldung an mindestens einen Teil der autonomen technischen Systeme übertragen wird.

11. Verfahren nach Anspruch 10, wobei anhand der computergestützten Simulation und einer vorgegebenen zweiten Regel ein zukünftiges, regelwidriges Betriebsverhalten detektiert wird, daraus eine Statusmeldung generiert wird und diese Statusmeldung an mindestens einen Teil der autonomen technischen Systeme übertragen wird.

12. Verfahren nach einem der vorhergehenden Ansprüche, wobei ein nicht-autonomes technisches System (NAS), das mit dem Kommunikationsnetzwerk verbunden ist,
- von mindestens einem überwachenden autonomen technischen System (ASobs1) das Betriebsverhalten des nicht-autonomen technischen Systems überwacht und anhand einer vorgegebenen dritten Regel ein regelwidriges Betriebsverhalten des nicht-autonomen technischen Systems (NAS) detektiert wird,
- eine Statusmeldung von mindestens einem Teil der anderen autonomen technischen Systeme bewertet und daraus eine Kontrollvorschrift für das nicht-autonome technische System abgeleitet wird
und
- das Betriebsverhalten des nicht-autonomen technischen Systems mittels einer Kontrollvorschrift von einem, dem nicht-autonomen technischen System zugeordneten, Kontrollmodul kontrolliert wird.

13. Vorrichtung zur gegenseitigen Überwachung und Kontrolle einer Vielzahl autonomer technischer Systeme, welche zumindest teilweise untereinander über ein Kommunikationsnetzwerk vernetzt sind,
die derart eingerichtet ist, die Schritte eines Verfahrens nach einem der Ansprüche 1 bis 12 durchzuführen, umfassend mindestens ein Überwachungsmodul (OM) eines autonomen, technischen Systems und mindestens ein Kontrollmodul (CTLM), das einem anderen autonomen technischen System zugeordnet ist.

14. Vorrichtung nach Anspruch 13, wobei mindestens ein Teil der autonomen technischen Systeme (AS1, AS2, AS3, ...) als überwachende autonome technische Systeme (ASobs1, ASobs2, ASobs3), umfassend jeweils ein Überwachungsmodul (OM1, OM2, OM3, ...) und mindestens einen Sensor (S), ausgestaltet sind und mindestens ein Teil der autonomen technischen Systeme (AS1, AS2, AS3, ...) jeweils ein Kontrollmodul (CTLM1, CTLM2, CTLM3, ...) umfassen, wobei mindestens ein Teil der Überwachungsmodule (OM1, OM2, OM3, ...) und mindestens ein Teil der Kontrollmodule (CTLM1, CTLM2, CTLM3, ...) über das Kommunikationsnetzwerk untereinander verbunden sind.

15. Vorrichtung (100) nach Anspruch 13 oder 14, wobei ein Kontrollmodul (CTLM) eine erste Kommunikationsschnittstelle (IF1) zum Kommunikationsnetzwerk (NW) zum Empfangen und Entschlüsseln einer verschlüsselten Datenübertragung umfasst.

16. Vorrichtung (100) nach Anspruch 13 oder 14, wobei ein Überwachungsmodul (OM) eine Bewertungseinheit (AM) zum Bewerten einer von der Bewertungseinheit (AM) generierten und/oder empfangenen Statusmeldung umfasst.

17. Vorrichtung (100) nach Anspruch 16, wobei ein Überwachungsmodul eine zweite Kommunikationsschnittstelle (IF2) zum Kommunikationsnetzwerk (NW) zum verschlüsselten Übertragen von Daten und Entschlüsseln von verschlüsselten Daten umfasst.

18. Vorrichtung (100) nach Anspruch 16 oder 17, wobei ein Überwachungsmodul (OM) eine Simulationseinheit (SIM) zum Simulieren eines Betriebsverhaltens eines anderen autonomen technischen Systems, basierend auf Sensordaten des überwachenden autonomen technischen Systems (ASobs1) und/oder auf Sensordaten anderer überwachender autonomer technischer Systeme (ASobs2, ASobs3, ASobs4,...) umfasst.

19. Computerprogrammprodukt, das direkt in einen programmierbaren Computer ladbar ist, umfassend Programmcodeteile, die dazu geeignet sind, die Schritte des Verfahrens nach einem der Ansprüche 1 bis 12 durchzuführen.

## Claims

1. Method for mutual monitoring and/or control of a plurality of autonomous technical systems which are at least partly interconnected via a communication network (NW), wherein the autonomous technical systems are in the form of autonomous vehicles, devices or robots which, for example, can move autonomously or can act automatically, wherein:
- at least one of the autonomous technical systems (AS1, AS2, AS3, ...) is in the form of a monitoring autonomous technical system (ASobs1) and monitors the operating behaviour of other autonomous technical systems (S1),
- an abnormal operating behaviour of a first autonomous technical system (AS1) of the autonomous technical systems (AS1, AS2, AS3, ...) is detected by the monitoring autonomous technical system (ASobs1) based on a specified first rule and a status message regarding the abnormal operating behaviour of the first autonomous technical system (AS1) of the autonomous technical systems (AS1, AS2, AS3, ...) is generated therefrom (S2),
- the status message is transmitted from the monitoring autonomous technical system (ASobs1) to some of the other autonomous technical systems (S3), wherein the status message includes identification information relating to the first autonomous technical system (AS1) and details about the abnormal operating behaviour,
- the status message is received by some of the other autonomous technical systems and jointly evaluated by them and, depending on the evaluation, a control rule is derived for the first autonomous technical system (AS1) of the autonomous technical systems (AS1, AS2, AS3, ...) (S4), wherein a result of the joint evaluation is determined from a majority decision of the other autonomous technical systems or from weighted evaluations of the other autonomous technical systems, and the control rule is derived based on the result of the joint evaluation
and
- the control rule is sent to a control module (CTLM) which is assigned to the first autonomous technical system (AS1) of the autonomous technical systems (AS1, AS2, AS3, ...), and the operating behaviour of the first autonomous technical system (AS1) of the autonomous technical systems (AS1, AS2, AS3, ...) is controlled by the control module (CTLM) according to the control rule (S5).

2. Method according to Claim 1, wherein a monitoring autonomous technical system (ASobs1) comprises at least one sensor (S), the sensor (S) records sensor data, and an abnormal operating behaviour of one of the other autonomous technical systems (AS1, AS2, AS3, ...) is detected using the sensor data.

3. Method according to either one of the preceding claims, wherein the status message is transmitted and/or the status message is jointly evaluated and/or the control rule is sent by means of encrypted data transmission via the communication network (NW).

4. Method according to any one of the preceding claims, wherein the status message is transmitted and/or the status message is jointly evaluated and/or the control rule is sent after mutual identification of the autonomous technical systems.

5. Method according to any one of the preceding claims, wherein several autonomous technical systems are in the form of monitoring autonomous technical systems (ASobs1, ASobs2, ASobs3, ...) and each of these monitoring autonomous systems transmits a status message to other autonomous technical systems (AS1, AS2, AS3, ...) and the status messages are jointly evaluated.

6. Method according to any one of the preceding claims, wherein the monitoring and/or the evaluation of a status message and/or the control according to a control rule of at least one autonomous technical system are carried out continuously.

7. Method according to any one of the preceding claims, wherein the monitoring and/or the evaluation of a status message and/or the control according to a control rule of at least one autonomous technical system are carried out at predetermined times.

8. Method according to any one of the preceding claims, wherein a weighting is assigned to each autonomous technical system that evaluates a status message and thus the joint evaluation of a status message is determined from weighted evaluations.

9. Method according to Claim 8, wherein the weighting is adjusted dynamically depending on a monitoring quality and/or on a rank of an autonomous technical system.

10. Method according to any one of the preceding claims, wherein a computer-aided simulation of an operating behaviour of another autonomous technical system (AS1, AS2, AS3, ...) is carried out by a monitoring autonomous technical system (ASobs1) based on sensor data of the monitoring autonomous technical system (ASobs1) and/or on sensor data of other monitoring autonomous technical systems (ASobs2, ASobs3, ASobs4, ...) and, based on the simulation, a prediction of a future operating behaviour is derived and transmitted as a status message to at least some of the autonomous technical systems.

11. Method according to Claim 10, wherein a future abnormal operating behaviour is detected using the computer-aided simulation and a specified second rule, a status message is generated therefrom and this status message is transmitted to at least some of the autonomous technical systems.

12. Method according to any one of the preceding claims, wherein, in a non-autonomous technical system (NAS) which is connected to the communication network,
- the operating behaviour of the non-autonomous technical system is monitored by at least one monitoring autonomous technical system (ASobs1) and, according to a specified third rule, an abnormal operating behaviour of the non-autonomous technical system (NAS) is detected,
- a status message is evaluated by at least some of the other autonomous technical systems and a control rule is derived therefrom for the non-autonomous technical system
and
- the operating behaviour of the non-autonomous technical system is controlled by a control module, assigned to the non-autonomous technical system, by means of a control rule.

13. Device for mutual monitoring and control of a plurality of autonomous technical systems which are at least partly interconnected via a communication network,
which is configured in such a manner as to carry out the steps of a method according to any one of Claims 1 to 12, comprising at least one monitoring module (OM) of an autonomous technical system and at least one control module (CTLM) which is assigned to another autonomous technical system.

14. Device according to Claim 13, wherein at least some of the autonomous technical systems (AS1, AS2, AS3, ...) are in the form of monitoring autonomous technical systems (ASobs1, ASobs2, ASobs3), each comprising one monitoring module (OM1, OM2, OM3, ...) and at least one sensor (S), and at least some of the autonomous technical systems (AS1, AS2, AS3, ...) each comprise a control module (CTLM1, CTLM2, CTLM3, ...), wherein at least some of the monitoring modules (OM1, OM2, OM3, ...) and at least some of the control modules (CTLM1, CTLM2, CTLM3, ...) are interconnected via the communication network.

15. Device (100) according to Claim 13 or 14, wherein a control module (CTLM) comprises a first communication interface (IF1) to the communication network (NW) for receiving and decrypting an encrypted data transfer.

16. Device (100) according to Claim 13 or 14, wherein a monitoring module (OM) comprises an evaluation unit (AM) for evaluating a status message generated and/or received by the evaluation unit (AM).

17. Device (100) according to Claim 16, wherein a monitoring module comprises a second communication interface (IF2) to the communication network (NW) for encrypted transmission of data and decryption of encrypted data.

18. Device (100) according to Claim 16 or 17, wherein a monitoring module (OM) comprises a simulation unit (SIM) for simulating an operating behaviour of another autonomous technical system, based on sensor data relating to the monitoring autonomous technical system (ASobs1) and/or on sensor data relating to other monitoring autonomous technical systems (ASobs2, ASobs3, ASobs4, ...).

19. Computer program product which can be directly loaded into a programmable computer, comprising program code parts suitable for carrying out the steps of the method according to any one of Claims 1 to 12.

## Revendications

1. Procédé de surveillance et/ou de commande mutuelle d'une pluralité de systèmes techniques autonomes qui sont au moins partiellement mis en réseau les uns avec les autres par l'intermédiaire d'un réseau de communication (NW), dans lequel les systèmes techniques autonomes sont conçus sous forme de véhicules, d'appareils ou de robots autonomes pouvant par exemple se déplacer de manière autonome ou agir automatiquement, dans lequel :
- au moins l'un des systèmes techniques autonomes (AS1, AS2, AS3, ...) est conçu sous la forme d'un système technique autonome de surveillance (ASobs1) et surveille le comportement de fonctionnement d'autres systèmes techniques autonomes (S1),
- un comportement de fonctionnement anormal d'un premier système technique autonome (AS1) des systèmes techniques autonomes (AS1, AS2, AS3, ...) est déterminé par le système technique autonome de surveillance (ASobs1) sur la base d'une première règle prédéfinie, et un message d'état sur le comportement de fonctionnement anormal du premier système technique autonome (AS1) des systèmes techniques autonomes (AS1, AS2, AS3, ...) est généré (S2) à partir de celui-ci,
- le message d'état est transmis (S3) du système technique autonome de surveillance (ASobs1) à une partie des autres systèmes techniques autonomes, le message d'état comprenant des informations d'identification du premier système technique autonome (AS1) et des détails sur le comportement de fonctionnement anormal,
- le message d'état est reçu par la partie des autres systèmes techniques autonomes et évalué conjointement par ceux-ci et, en fonction de l'évaluation, une spécification de contrôle pour le premier système technique autonome (AS1) des systèmes techniques autonomes (AS1, AS2, AS3, ...) est dérivée (S4), un résultat de l'évaluation conjointe est établi à partir d'une décision majoritaire des autres systèmes techniques autonomes ou à partir d'évaluations pondérées des autres systèmes techniques autonomes, et la spécification de contrôle est dérivée sur la base du résultat de l'évaluation conjointe
et
- la spécification de contrôle est transmise à un module de contrôle (CTLM) qui est associé au premier système technique autonome (AS1) des systèmes techniques autonomes (AS1, AS2, AS3, ...), et le comportement de fonctionnement du premier système technique autonome (AS1) des systèmes techniques autonomes (AS1, AS2, AS3, ...) est commandé (S5) par le module de contrôle (CTLM) sur la base de la spécification de contrôle.

2. Procédé selon la revendication 1, dans lequel un système technique autonome de surveillance (ASobs1) comprend au moins un capteur (S), le capteur (S) détecte des données de capteur et un comportement de fonctionnement anormal de l'un des autres systèmes techniques autonomes (AS1, AS2, AS3, ...) est détecté sur la base des données de capteur.

3. Procédé selon l'une quelconque des revendications précédentes, dans lequel la transmission du message d'état et/ou l'évaluation conjointe du message d'état et/ou la transmission de la spécification de contrôle s'effectuent au moyen d'une transmission de données cryptée par l'intermédiaire du réseau de communication (NW).

4. Procédé selon l'une quelconque des revendications précédentes, dans lequel la transmission du message d'état et/ou l'évaluation conjointe du message d'état et/ou la transmission de la spécification de contrôle s'effectuent après identification mutuelle des systèmes techniques autonomes entre eux.

5. Procédé selon l'une quelconque des revendications précédentes, dans lequel plusieurs systèmes techniques autonomes sont conçus sous forme de systèmes techniques autonomes de surveillance (ASobs1, ASobs2, ASobs3, ...) et chacun de ces systèmes autonomes de surveillance transmet un message d'état à d'autres systèmes techniques autonomes (AS1, AS2, AS3, ...) et une évaluation conjointe des messages d'état est effectuée.

6. Procédé selon l'une quelconque des revendications précédentes, dans lequel la surveillance et/ou l'évaluation d'un message d'état et/ou la commande sont effectuées en continu sur la base d'une spécification de contrôle d'au moins un système technique autonome.

7. Procédé selon l'une quelconque des revendications précédentes, dans lequel la surveillance et/ou l'évaluation d'un message d'état et/ou la commande sont effectuées à des instants prédéfinis sur la base d'une spécification de contrôle d'au moins un système technique autonome.

8. Procédé selon l'une quelconque des revendications précédentes, dans lequel une pondération est associée à chaque système technique autonome qui évalue un message d'état, et l'évaluation conjointe d'un message d'état est ainsi déterminée à partir d'évaluations pondérées.

9. Procédé selon la revendication 8, dans lequel la pondération est adaptée dynamiquement en fonction d'une qualité de surveillance et/ou d'un rang d'un système technique autonome.

10. Procédé selon l'une quelconque des revendications précédentes, dans lequel une simulation assistée par ordinateur d'un comportement de fonctionnement d'un autre système technique autonome (AS1, AS2, AS3, ...) est effectuée à partir d'un système technique autonome de surveillance (ASobs1) sur la base des données de capteur du système technique autonome de surveillance (ASobs1) et/ou de données de capteur d'autres systèmes techniques autonomes de surveillance (ASobs2, ASobs3, ASobs4, ...), et un comportement de fonctionnement futur est dérivé sur la base de la simulation, une prédiction concernant et est transmise sous forme de message d'état à au moins certains des systèmes techniques autonomes.

11. Procédé selon la revendication 10, dans lequel un comportement de fonctionnement anormal futur est détecté sur la base de la simulation assistée par ordinateur et d'une deuxième règle prédéfinie, un message d'état est généré à partir de celle-ci, et ce message d'état est transmis à au moins une partie des systèmes techniques autonomes.

12. Procédé selon l'une quelconque des revendications précédentes, dans lequel un système technique non autonome (NAS) est connecté au réseau de communication,
- le comportement de fonctionnement du système technique non autonome est surveillé par au moins un système technique autonome de surveillance (ASobs1) et un comportement de fonctionnement anormal du système technique non autonome (NAS) est détecté sur la base d'une troisième règle prédéfinie,
- un message d'état d'au moins une partie des autres systèmes techniques autonomes est évalué et une spécification de contrôle destinée au système technique non autonome en est dérivée
et
- le comportement de fonctionnement du système technique non autonome est contrôlé par un module de contrôle associé au système technique non autonome au moyen d'une spécification de contrôle.

13. Dispositif de surveillance et de commande mutuelles d'une pluralité de systèmes techniques autonomes qui sont au moins partiellement mis en réseau les uns avec les autres par l'intermédiaire d'un réseau de communication, qui est configuré de manière à exécuter les étapes d'un procédé selon l'une quelconque des revendications 1 à 12, comprenant au moins un module de surveillance (OM) d'un système technique autonome et au moins un module de contrôle (CTLM) associé à un autre système technique autonome.

14. Dispositif selon la revendication 13, dans lequel au moins une partie des systèmes techniques autonomes (AS1, AS2, AS3, ...) est conçue sous forme de systèmes techniques autonomes de surveillance (ASobs1, ASobs2, ASobs3), qui comprennent respectivement un module de surveillance (OM1, OM2, OM3, ...) et au moins un capteur (S), et au moins une partie des systèmes techniques autonomes (AS1, AS2, AS3, ...) comprennent respectivement un module de contrôle (CTLM1, CTLM2, CTLM3, ...), au moins une partie des modules de surveillance (OM1, OM2, OM3, ...) et au moins une partie des modules de contrôle (CTLM1, CTLM2, CTLM3, ...) étant reliés les uns aux autres par l'intermédiaire du réseau de communication.

15. Appareil (100) selon la revendication 13 ou 14, dans lequel un module de contrôle (CTLM) comprend une première interface de communication (IF1) vers le réseau de communication (NW) pour recevoir et décrypter une transmission de données cryptée.

16. Dispositif (100) selon la revendication 13 ou 14, dans lequel un module de surveillance (OM) comprend une unité d'évaluation (AM) pour évaluer un message d'état généré et/ou reçu par l'unité d'évaluation (AM).

17. Dispositif (100) selon la revendication 16, dans lequel un module de surveillance comprend une deuxième interface de communication (IF2) vers le réseau de communication (NW) pour la transmission cryptée de données et le décryptage de données cryptées.

18. Dispositif (100) selon la revendication 16 ou 17, dans lequel un module de surveillance (OM) comprend une unité de simulation (SIM) pour simuler un comportement de fonctionnement d'un autre système technique autonome, sur la base de données de capteur du système technique autonome de surveillance (ASobs1) et/ou de données de capteur d'autres systèmes techniques autonomes de surveillance (ASobs2, ASobs3, ASobs4, ...).

19. Produit de programme d'ordinateur pouvant être chargé directement dans un ordinateur programmable, comprenant des parties de code de programme qui sont appropriées pour la mise en œuvre des étapes du procédé selon l'une quelconque des revendications 1 à 12.
